(19) Europäisches Patentamt / European Patent Office / Office européen des brevets

(11) **EP 3 284 715 B1**

(12) **EUROPEAN PATENT SPECIFICATION**

(45) Date of publication and mention
of the grant of the patent:
**28.08.2019 Bulletin 2019/35**

(51) Int Cl.:
***H01L 21/67*** *(2006.01)*

(21) Application number: **17172327.3**

(22) Date of filing: **22.05.2017**

(54) **SYSTEM AND METHOD FOR CHARACTERIZING CRITICAL PARAMETERS RESULTING FROM A SEMICONDUCTOR DEVICE FABRICATION PROCESS**

SYSTEM UND VERFAHREN ZUR CHARAKTERISIERUNG VON KRITISCHEN PARAMETERN, DIE AUS EINEM HALBLEITERBAUELEMENTHERSTELLUNGSVERFAHREN RESULTIEREN

SYSTÈME ET PROCÉDÉ PERMETTANT DE CARACTÉRISER DES PARAMÈTRES CRITIQUES RÉSULTANT D'UN PROCÉDÉ DE FABRICATION DE DISPOSITIF SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.08.2016 US 201615240701**

(43) Date of publication of application:
**21.02.2018 Bulletin 2018/08**

(73) Proprietor: **NXP USA, Inc.**
**Austin TX 78735 (US)**

(72) Inventors:
• **HOLM, Paige M.**
**5656 AG Eindhoven (NL)**

• **LIU, Lianjun**
**5656 AG Eindhoven (NL)**

(74) Representative: **Pomper, Till**
**NXP Semiconductors**
**Intellectual Property Group**
**134 avenue Eisenhower**
**BP 72329**
**31023 Toulouse Cedex 1 (FR)**

(56) References cited:
**US-A1- 2003 022 397    US-B1- 7 935 965**

EP 3 284 715 B1

**Description**

**TECHNICAL FIELD OF THE INVENTION**

The present invention relates generally to semiconductor device fabrication processes. More specifically, the present invention relates to a system and method for characterizing critical parameters of a device manufactured in accordance with a semiconductor device fabrication process.

**BACKGROUND OF THE INVENTION**

Microelectromechanical systems (MEMS) technology provides a way to make very small mechanical structures and integrate these structures with electrical devices on a single substrate using conventional batch semiconductor processing techniques. One common application of MEMS is the design and manufacture of sensor devices. MEMS sensor devices are widely used in applications such as automotive, inertial guidance systems, household appliances, game devices, protection systems for a variety of devices, and many other industrial, scientific, and engineering systems.

Conventional MEMS fabrication processes typically employ a slab (i.e., structural layer) of semiconductor material of a given resistivity and thickness into which features are etched to form electromechanical structures that perform the desired functions needed to realize MEMS devices, such as accelerometers and gyroscopes. The critical device parameters include, for example, the electrical resistivity of the structural layer, the thickness of the structural layer, and the width of the etched features in which the width is determined by the original mask pattern dimension and the amount of undercut incurred during the etch process. All three of these key critical parameters (i.e., resistivity, thickness, and amount of undercut) typically vary slightly across a wafer, wafer to wafer, and/or process lot to process lot. Due to these variations, it may be necessary to routinely monitor these critical parameters in order to optimize production yields, device performance, and quality of the MEMS devices.

Some prior art techniques electrically measure the sheet resistance of the MEMS structural layer by using conventional van der Pauw patterns or Kelvined resistor structures. However, to determine the local resistivity of the structural layer, the layer thickness and/or the lateral geometries of the structures must be accurately known. Because the lateral dimensions (and their variations of interest) of typical MEMS features is on the order of a micron or less, it is not typically feasible to use optical microscopy. Accordingly, more complex Scanning Electron Microscopy (SEM) inspections are needed to obtain the lateral physical dimensions. Furthermore, in order to obtain the local structural layer thickness uniformity information, a wafer must be sacrificed for cross section and multiple measurements are thereafter performed along this cross section. Thus, it is not practically and cost effectively feasible to routinely map wafers with this approach. Nor does it provide data from the actual product wafers where such date would be of greatest value.

Other prior art techniques utilize capacitance measurement on some type of dynamically driven, oscillating or resonance MEMS structures. Capacitance measurements on these movable structures involve complex, sophisticated testing techniques and may involve comparison to numerical analysis and simulations. Further, these techniques are primarily focused on extracting the lateral dimensions of a MEMS features (more specifically, amount of etch undercut) and assume that the thickness of the structural layer is known. In actually, the thickness of the structural layer and the gap (which includes etch undercut) are coupled together in the capacitance measurement.

For instance, US 2003 / 022 397 A1 discloses a method and inspection structure for monitoring and measuring the process, the completion and the result of substrate through etching in a substrate. Sacrificial electrodes are arranged close to a desired etching window on the substrate. The substrate through etching process is monitored by measuring the electric characteristic of the substrate or the sacrificial electrodes or the characteristics of them.

**BRIEF DESCRIPTION OF THE DRAWINGS**

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.

FIG. 1 shows a generalized top view of a process control monitoring system in accordance with an embodiment;
FIG. 2 shows a simplified top view of a wafer structure that includes a plurality of semiconductor devices and at least one process control monitoring system of FIG. 1;
FIG. 3 shows a top view of the process control monitoring system of FIG. 1 depicting the resistance and capacitances used to determine the critical device parameters;
FIG. 4 shows a cross-sectional side view of one of the structures of the process control monitoring system along section lines 4-4 of FIG. 3;

FIG. 5 shows a top view of an example layout of one of the structures of the process control monitoring system; and
FIG. 6 shows a flowchart of a critical parameter characterization process in accordance with another embodiment.

## DETAILED DESCRIPTION

In overview, embodiments disclosed herein entail a process control monitoring system and a method for characterizing critical device parameters resulting from a semiconductor device fabrication process, where the semiconductor device fabrication process is utilized to form the process control monitoring system as well as a plurality of semiconductor devices in a structural layer of the substrate. The process control monitoring system includes three related structures, but with different critical dimensions. The general configuration of each of the three structures includes a single fixed "finger" of a given width and length etched into a structural layer of a given thickness. On each side of the finger, there is a given spacing to adjacent sidewalls of the structural layer. Various electrical contacts are made to the finger and to the adjacent sidewalls of the structural layer in order to obtain a resistance measurement of the finger and to measure a static, differential capacitance between the finger and the surrounding sidewalls. The resistance and capacitance measurements enable electrical characterization of, for example, a product wafer, in order to extract the critical device parameters of the electrical resistivity of the structural layer, the thickness of the structural layer, and the amount of undercut of the etched features. The system and associated methodology enables the extraction of these critical device parameters without the need for sacrificial wafers, cross sectioning, or the use of complex SEM analysis. Accordingly, variations in resistivity, material thickness, and amount of undercut can be readily monitored in order to optimize production yields, device performance, and the quality of semiconductor devices, such as microelectromechanical systems (MEMS) devices.

The instant disclosure is provided to further explain in an enabling fashion the best modes, at the time of the application, of making and using various embodiments in accordance with the present invention. The disclosure is further offered to enhance an understanding and appreciation for the inventive principles and advantages thereof, rather than to limit in any manner the invention. The invention is defined solely by the appended claims including any amendments made during the pendency of this application and all equivalents of those claims as issued.

It should be understood that the use of relational terms, if any, such as first and second, top and bottom, and the like are used solely to distinguish one from another entity or action without necessarily requiring or implying any actual such relationship or order between such entities or actions. Furthermore, some of the figures may be illustrated using various shading and/or hatching to distinguish the different elements produced within the various structural layers. These different elements within the structural layers may be produced utilizing current and upcoming microfabrication techniques of depositing, patterning, etching, and so forth. Accordingly, although different shading and/or hatching is utilized in the illustrations, the different elements within the structural layers may be formed out of the same material.

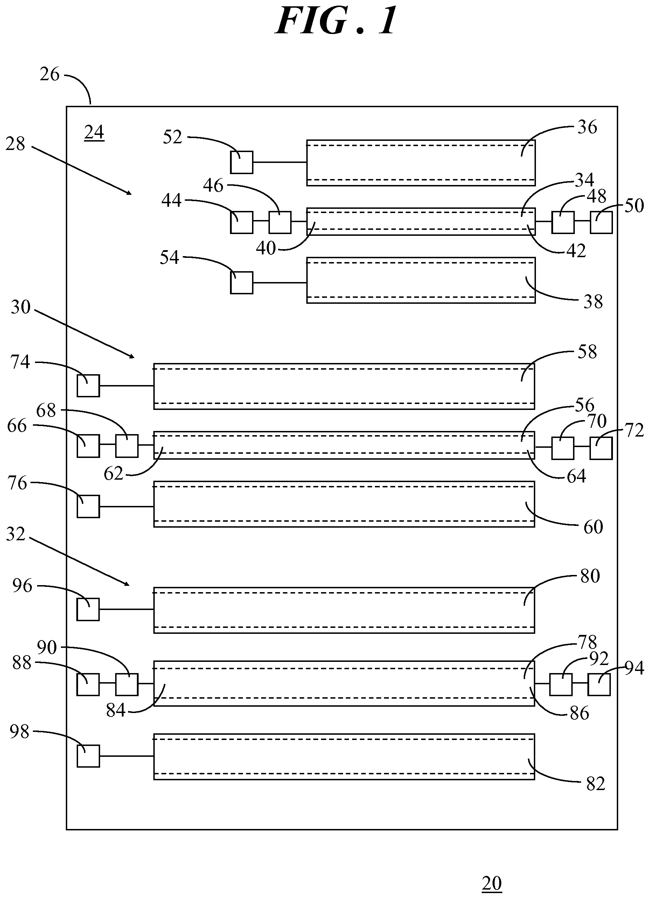

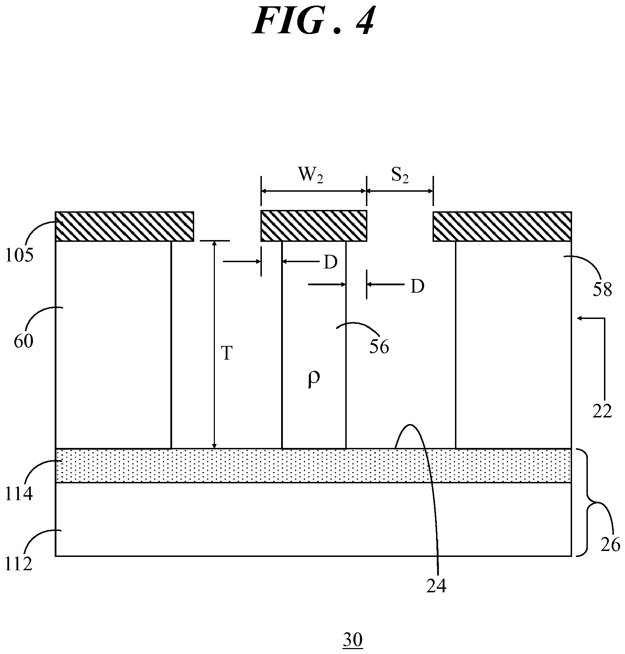

Referring to FIG. 1, FIG. 1 shows a generalized top view of a process control monitoring system 20 in accordance with an embodiment. Process control monitoring system 20 is generally formed in a structural layer 22 (shown in the side view of FIG. 4) on a surface 24 of a substrate 26. Process control monitoring system 20 generally includes a first structure 28, a second structure 30, and a third structure 32 formed in structural layer 22.

First structure 28 includes a first finger 34 interposed between a first pair of sidewalls 36, 38. First finger 34 has a first end 40 and a second end 42. A first pair of terminals 44, 46 is in electrical communication with first end 40 of first finger 34, and a second pair of terminals 48, 50 is in electrical communication with second end 42. In addition, a first contact 52 is in electrical communication with sidewall 36 and a second contact 54 is in electrical communication with sidewall 38. The term "electrical communication" refers to an electrical connection via, for example, conductive traces, bond wires, or any other technique implemented to provide electrical continuity between respective terminals or contacts and their respective structures.

Similarly, second structure 30 includes a second finger 56 interposed between a second pair of sidewalls 58, 60. Second finger 56 has a first end 62 and a second end 64. A first pair of terminals 66, 68 is in electrical communication with first end 62 of second finger 56, and a second pair of terminals 70, 72 is in electrical communication with second end 64. In addition, a first contact 74 is in electrical communication with sidewall 58 and a second contact 76 is in electrical communication with sidewall 60.

Third structure 32 includes a third finger 78 interposed between a third pair of sidewalls 80, 82. Third finger 78 has a first end 84 and a second end 86. A first pair of terminals 88, 90 is in electrical communication with first end 84 of third finger 78, and a second pair of terminals 92, 94 is in electrical communication with second end 86. In addition, a first contact 96 is in electrical communication with sidewall 80 and a second contact 98 is in electrical communication with sidewall 82.

First finger 34 is immovable relative to its corresponding first pair of sidewalls 36, 38. Likewise, second finger 56 is immovable relative to its corresponding second pair of sidewalls 58, 60. And, third finger 78 is immovable relative to its corresponding third pair of sidewalls 80, 82. That is first, second, and third fingers 34, 56, 78 and sidewalls 36, 38, 58, 60, 80, 82 are all fixedly (i.e., non-movably) coupled to surface 24 of substrate 26.

As will be discussed in significantly greater detail below, the resistance of each of first, second, and third fingers 34, 56, 78 and the static capacitance between each of first, second, and third fingers 34, 56, 78 and its immediate surroundings can be measured. The resistance and capacitance measurements for each of first, second, and third, structures 28, 30, 32 having differing critical dimensions can be utilized to determine critical device parameters (e.g., resistivity, thickness of the structural layer, and amount of undercut of the etched features) resulting from the particular semiconductor fabrication process implemented to form them.

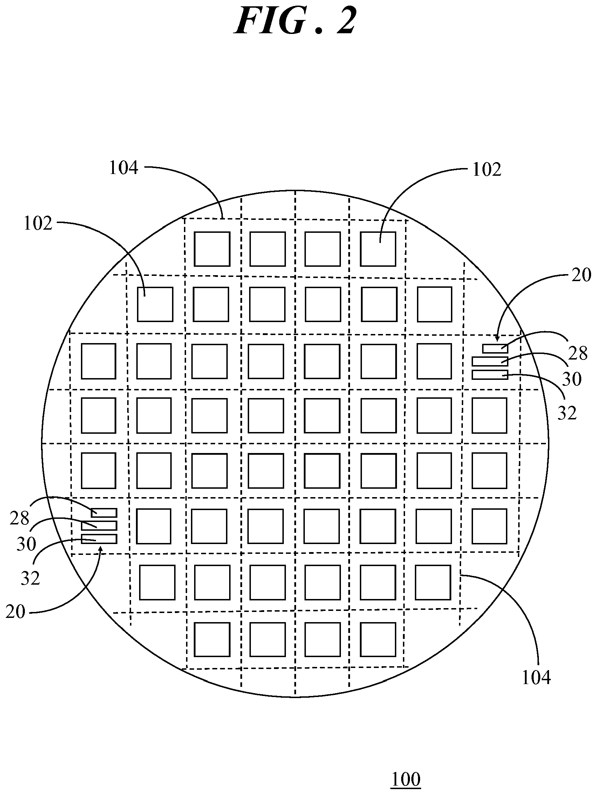

Referring now to FIG. 2, FIG. 2 shows a simplified top view of a wafer structure 100 that includes a plurality of semiconductor devices 102 and at least one process control monitoring system 20. Wafer structure 100 is shown with a number of semiconductor devices 102 formed therein that are separated by scribe lines 104, where each semiconductor device 102 may include a MEMS or MEMS-like structure having a semiconductor layer (e.g., structural layer 22 of FIG. 4) and narrow features etched into structural layer 22. Semiconductor devices 102 are represented by boxes for simplicity of illustration. However, those skilled in the art will recognize that each of semiconductor devices 102 can include a plurality of movable and non-movable features. In accordance with an embodiment, semiconductor devices 102 and first, second, and third structures 28, 30, 32 of process control monitoring system 20 are concurrently fabricated using the same semiconductor device fabrication process. Accordingly, the critical device parameters extracted utilizing process control monitoring system 20 and methodology described below will apply equivalently to the features of semiconductor devices 102.

In this example, two process control monitoring systems 20 are shown. However, wafer structure 100 can include any suitable quantity of process control monitoring systems 20 distributed across wafer structure 100. Further, the two process control monitoring systems 20 are also shown in areas of wafer structure 100 that are fully surrounded by scribe lines 104. However, process control monitoring systems 20 can be formed at any suitable unused portion of wafer structure 100 since following characterization of the critical parameters and subsequent dicing of wafer structure 100 along scribe lines 104, they will no longer be used.

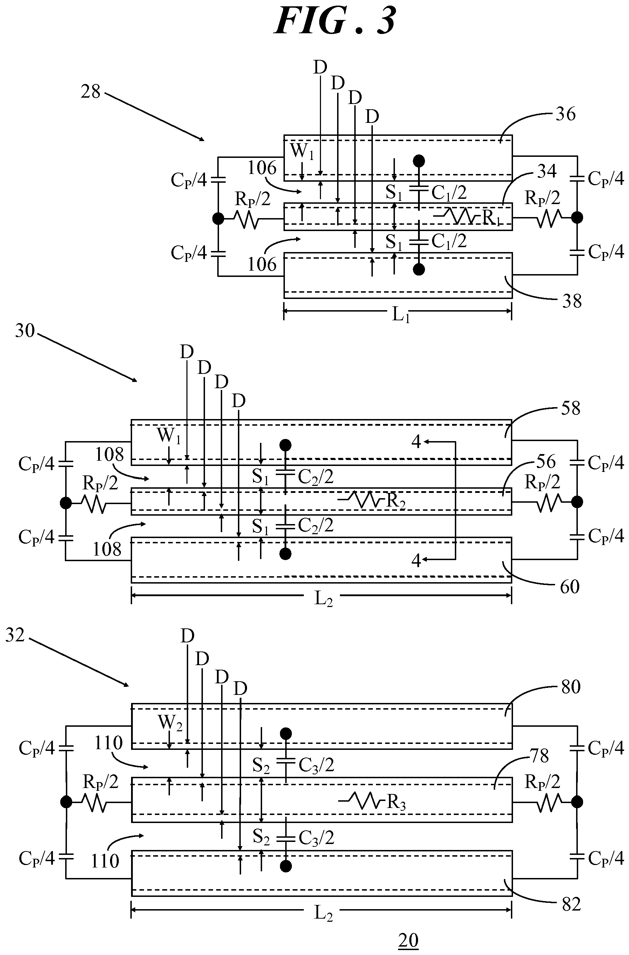

Referring to FIGS. 3 and 4, FIG. 3 shows a top view of the process control monitoring system 20 depicting the resistance and capacitances used to determine the critical device parameters of material resistivity, layer thickness, and amount of undercut of the etched features and FIG. 4 shows a cross-sectional side view of second structure 30 of process control monitoring system 20 along section lines 4-4 of FIG. 3. That is, FIGs. 3 and 4 show generalized sketches of first, second, and third structures 28, 30, 32 that are labeled with the parameters used in the analysis. An algorithm described below, which may be realized as program code executed by a computing system (not shown), is used to extract the critical device parameters from simple resistance and capacitance measurements on the static (i.e., non-movable) structures 28, 30, 32.

In the sketches provided in FIGs. 3 and 4, L is the printed finger length and W is the printed finger width as determined by the original pattern dimension of an etch mask 105, where each of the length and width is parallel to surface 24 of substrate 26 (FIG. 1). First finger 34 is separated from each of sidewalls 36, 38 by a gap 106 having a dimension or width referred to herein as a spacing, S. Likewise, second finger 56 is separated from each of sidewalls 58, 60 by a gap 108 having a spacing, S, and third finger 78 is separated from each of sidewalls 80, 82 by a gap 110 having a spacing, S.

First finger 34 exhibits a first length, $L_1$, and a first width, $W_1$. Additionally, first finger 34 is separated from each of the adjacent sidewalls 36, 38 by a first spacing, $S_1$. Second finger 56 exhibits a second length, $L_2$, and first width, $W_1$. Additionally, second finger 56 is separated from each of the adjacent sidewalls 58, 60 by first spacing, $S_1$. Third finger 78 exhibits second length, $L_2$, and a second width, $W_2$. Additionally, third finger 78 is separated from each of the adjacent sidewalls 80, 82 by a second spacing, $S_2$. In an embodiment, first length, $L_1$, differs from second length, $L_2$, first width, $W_1$, differs from second width, $W_2$, and first spacing, $S_1$, differs from second spacing, $S_2$.

As exemplified in FIG. 4, a substrate structure may be a silicon on insulator (SOI) wafer that includes a handle substrate 112, a buried oxide layer 114, and a semiconductor layer, referred to herein as structural layer 22. The features of semiconductor devices 102 (FIG. 3) and process control monitoring system 20 are formed in structural layer 22. Thus, each of first, second, and third fingers 34, 56, 78 exhibits a thickness, T, perpendicular to surface 24 of substrate 26 corresponding to the thickness of structural layer 22, where the thickness, T, is generally equivalent for each of the first, second, and third fingers 34, 56, 78.

With continued reference to FIGs. 3 and 4, the process variables (i.e., critical device parameters) to be monitored utilizing first, second, and third structures 28, 30, 32 include an amount of undercut of the etched features, referred to herein as an etch undercut parameter, D, the resistivity parameter, $\rho$, of structural layer 22, and the thickness parameter, T, of structural layer 22. $R_1$, $R_2$, $R_3$ are the measured resistances and $C_1$, $C_2$, $C_3$ are the measured capacitances of first, second, and third structures 28, 30, 32, respectively. Thus, $R_1$, $R_2$, $R_3$, $C_1$, $C_2$, $C_3$ are known since they can be directly measured. $R_P$ and $C_P$ are the parasitic resistance and capacitance, respectively, of first, second, and third structures 28, 30, and 32.

$R_1$ and $C_1$ can be characterized by the following equations:

$$R_1 = \frac{\rho L_1}{(W_1 - 2D)T} + R_P \tag{1}$$

$$C_1 = \frac{2\varepsilon L_1 T}{(S_1 + 2D)} + C_P \tag{2}$$

Similarly, $R_2$ and $C_2$ can be characterized by the following equations:

$$R_2 = \frac{\rho L_2}{(W_1 - 2D)T} + R_P \tag{3}$$

$$C_2 = \frac{2\varepsilon L_2 T}{(S_1 + 2D)} + C_P \tag{4}$$

And, $R_3$ and $C_3$ can be characterized by the following equations:

$$R_3 = \frac{\rho L_2}{(W_2 - 2D)T} + R_P \tag{5}$$

$$C_3 = \frac{2\varepsilon L_2 T}{(S_2 + 2D)} + C_P \tag{6}$$

The system of equations (1), (2), (3), (4), (5), and (6) can be solved by first subtracting pairs of equations to eliminate the measurement parasitics (i.e., $R_P$ and $C_P$). The parasitics can be eliminated from the length variation structures as follows:

$$(R_1 - R_2) = \frac{\rho(L_1 - L_2)}{(W_1 - 2D)T} \tag{7}$$

$$(C_1 - C_2) = \frac{2\varepsilon T(L_1 - L_2)}{(S_1 + 2D)} \tag{8}$$

Then the parasitics can be eliminated from the width variation structures as follows:

$$(R_2 - R_3) = \frac{\rho L_2}{T}\left[\frac{1}{(W_1 - 2D)} - \frac{1}{(W_2 - 2D)}\right] \tag{9}$$

$$(C_2 - C_3) = 2\varepsilon L_2 T\left[\frac{1}{(S_1 + 2D)} - \frac{1}{(S_2 + 2D)}\right] \tag{10}$$

The RC products of equations (7) and (8) eliminates the thickness parameter, T, as follows:

$$(R_1 - R_2)(C_1 - C_2) = \frac{2\varepsilon\rho(L_1 - L_2)^2}{(W_1 - 2D)(S_1 + 2D)} \tag{11}$$

Solving equation (11) for the resistivity parameter, $\rho$, yields an equation (12) in the last remaining variable, i.e., the etch undercut parameter, D, which can be used to solve for resistivity parameter, $\rho$, after etch undercut parameter,

D is determined.

$$\rho = \frac{(R_1-R_2)(C_1-C_2)(W_1-2D)(S_1+2D)}{2\varepsilon(L_1-L_2)^2} \qquad (12)$$

To solve for the etch undercut parameter, D, the RC product of equations (9) and (10) is determined to again eliminate the thickness parameter, T, as follows:

$$(R_2-R_3)(C_2-C_3) = 2\varepsilon\rho L_2^2 \left[\frac{1}{(W_1-2D)}-\frac{1}{(W_2-2D)}\right]\left[\frac{1}{(S_1+2D)}-\frac{1}{(S_2+2D)}\right] \qquad (13)$$

Now substituting for the resistivity parameter, $\rho$, from equation (12) yields the following:

$$(R_2-R_3)(C_2-C_3) = \frac{(R_1-R_2)(C_1-C_2)(w_1-2D)(s_1+2D)L_2^2}{(L_1-L_2)^2}\left[\frac{1}{(W_1-2D)}-\frac{1}{(W_2-2D)}\right]\left[\frac{1}{(S_1+2D)}-\right.$$
$$\left.\frac{1}{(S_2+2D)}\right] \qquad (14)$$

Distributing the two numerator factors containing, etch undercut parameter, D, into the two bracketed terms gives:

$$(R_2-R_3)(C_2-C_3) = \frac{(R_1-R_2)(C_1-C_2)L_2^2}{(L_1-L_2)^2}\left[1-\frac{(W_1-2D)}{(W_2-2D)}\right]\left[1-\frac{(S_1+2D)}{(S_2+2D)}\right] \qquad (15)$$

Note that the form of equation (15) implies that if either of the two widths or the two spacings are identical (i.e., $W_1=W_2$ or $S_1=S_2$) then the analysis becomes invalid. Continuing the numerical analysis:

$$\frac{(R_2-R_3)(C_2-C_3)(L_1-L_2)^2}{(R_1-R_2)(C_1-C_2)L_2^2} = \left[1-\frac{(W_1-2D)}{(W_2-2D)}\right]\left[1-\frac{(S_1+2D)}{(S_2+2D)}\right] \qquad (16)$$

$$\frac{(R_2-R_3)(C_2-C_3)(L_1-L_2)^2}{(R_1-R_2)(C_1-C_2)L_2^2} = \left[\frac{(W_2-2D)-(W_1-2D)}{(W_2-2D)}\right]\left[\frac{(S_2+2D)-(S_1+2D)}{(S_2+2D)}\right] \qquad (17)$$

And continuing the expansion:

$$\frac{(R_2-R_3)(C_2-C_3)(L_1-L_2)^2}{(R_1-R_2)(C_1-C_2)L_2^2} = \left[\frac{(W_2-W_1)}{(W_2-2D)}\right]\left[\frac{(S_2-S_1)}{(S_2+2D)}\right] \qquad (18)$$

$$\frac{(R_2-R_3)(C_2-C_3)(L_1-L_2)^2}{(R_1-R_2)(C_1-C_2)L_2^2} = \left[\frac{(W_2-W_1)(S_2-S_1)}{(W_2-2D)(S_2+2D)}\right] \qquad (19)$$

$$\frac{(R_2-R_3)(C_2-C_3)(L_1-L_2)^2}{(R_1-R_2)(C_1-C_2)L_2^2} = \left[\frac{(W_2-W_1)(S_2-S_1)}{-4D^2+(2W_2-2S_2)D+W_2S_2}\right] \qquad (20)$$

Now rearranging and putting into standard quadratic form:

$$-4D^2 + (2W_2-2S_2)D + W_2S_2 = \frac{(R_1-R_2)(C_1-C_2)L_2^2(W_2-W_1)(S_2-S_1)}{(R_2-R_3)(C_2-C_3)(L_1-L_2)^2} \qquad (21)$$

$$4D^2 + (2S_2 - 2W_2)D + \frac{(R_1-R_2)(C_1-C_2)L_2^2(W_2-W_1)(S_2-S_1)}{(R_2-R_3)(C_2-C_3)(L_1-L_2)^2} - W_2S_2 = 0 \qquad (22)$$

In some embodiments, the width, W, and the spacing, S, are equivalent. That is, the first width is equivalent to the first spacing ($W_1=S_1=X_1$) and the second width is equivalent to the second spacing ($W_2=S_2\equiv X_2$), but $W_1$ is different from $W_2$ and $S_1$ is different from $S_2$ amongst first, second, and third structures 28, 30, 32 (i.e., $X_1 \neq X_2$). In such a configuration, some simplification can be leveraged, as follows:

$$4D^2 + \left[\frac{(R_1-R_2)(C_1-C_2)L_2^2(X_2-X_1)^2}{(R_2-R_3)(C_2-C_3)(L_1-L_2)^2} - X_2^2\right] = 0 \qquad (23)$$

$$D = \frac{1}{2}\sqrt{X_2^2 - \frac{(R_1-R_2)(C_1-C_2)L_2^2(X_2-X_1)^2}{(R_2-R_3)(C_2-C_3)(L_1-L_2)^2}} \qquad (24)$$

Once the etch undercut parameter, D, has been computed from either of equations (22) or (24), then the resistivity parameter, $\rho$, can be determined from equation (12), and the thickness parameter, T, can be determined from either of equations (7), (8), (9), or (10). Most accurately, however, the thickness parameter, T, can be determined from equation (8), as follows:

$$T = \frac{(C_1-C_2)(S_1+2D)}{2\varepsilon(L_1-L_2)} \qquad (25)$$

As demonstrated above, the judiciously selected first and second lengths, first and second widths, and first and second widths for associated ones of first, second, and third fingers 34, 56, 78 are utilized to determine the critical device parameters. That is, the construct of first, second, and third structures 28, 30, 32 together with the analysis routines form a self-consistent method of extracting the three key physical device parameters of MEMS structural layer resistivity parameter ($\rho$), thickness parameter (T), and etch undercut parameter (D) directly from the electrical resistance and capacitance measurements.

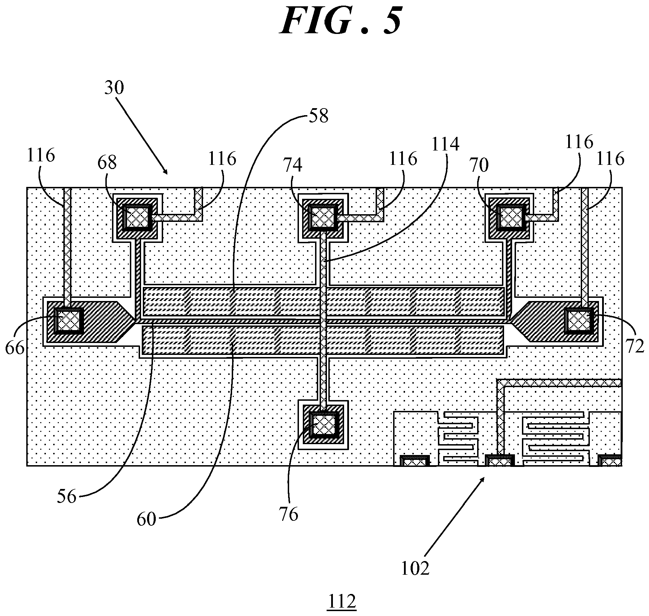

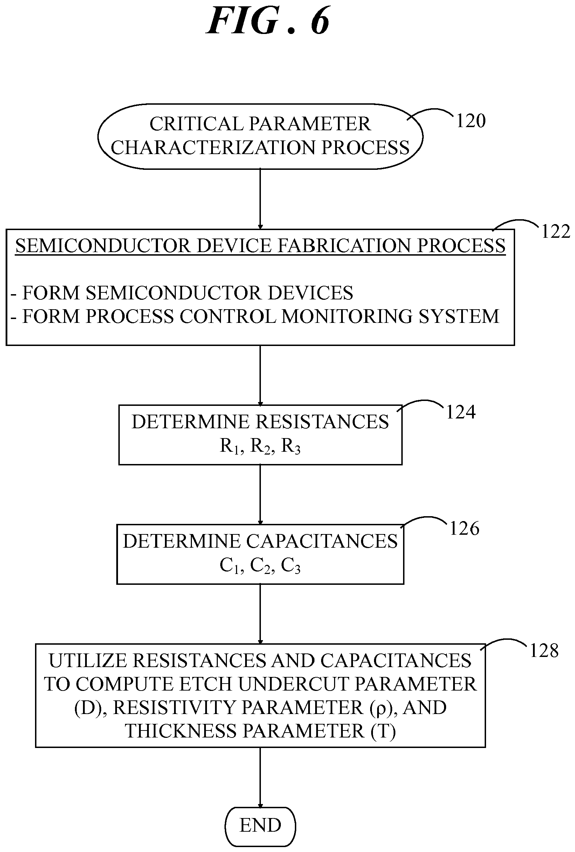

FIG. 5 shows a top view of an example layout 112 of one of the structures of the process control monitoring system 20 (FIG. 1). In this example, layout 112 includes second structure 30 having second finger 56 interposed between second pair of sidewalls 58, 60. Further, first pair of terminals 66, 68, second pair of terminals 70, 72 connected with second finger 56, and first and second contacts 74, 76 connected with second pair of sidewalls 58, 60 (as described above) are also illustrated in example layout 112. An electrically conductive trace 114 interconnects first and second contacts 74, 76, and various electrically conductive input/output (I/O) traces 116 are used to connect first pair of terminals 66, 68, second pair of terminals 70, 72, first contact 74, and second contact 76 to measurement equipment (generally discussed below in connection with FIG. 6). Layout 112 additionally shows a portion of one of semiconductor devices 102 which may include a combination of movable and nonmovable features (e.g., a comb structure with movable mass) and electrical connections.

A stippled pattern over much of structural layer 22 indicates a dielectric material overlying the structural features formed within structural layer 22 to yield a buried semiconductor layer. However, the stippled pattern is not shown over second structure 30 for clarity of illustration. It should be understood that the dielectric material may also be disposed between conductive traces 114, 116 and the underlying structural layer 22 to provide suitable electrical isolation between various features.

FIG. 6 shows a flowchart of a critical parameter characterization process 120 in accordance with another embodiment. Critical process characterization process 120 may be implemented in connection with any wafer processing technology (i.e., semiconductor device fabrication process) for which a quantitative assessment of the critical device parameters of resistivity, structural layer thickness, and etch undercut parameters are desired.

At a block 122, a semiconductor fabrication process that includes operations of, for example, patterning, deposition, and etching is implemented to form wafer structure 100 (FIG. 2) that includes semiconductor devices 102 (FIG. 2) and process control monitoring system 20 (FIG. 1) in structural layer 22 (FIG. 4).

At a block 124, resistances $R_1$, $R_2$, $R_3$ of corresponding first, second, and third fingers 34, 56, 78 are determined. By way of example, $R_1$, $R_2$, $R_3$ may be measured utilizing a four-terminal resistance measurement device (e.g., ohmmeter) capable of performing four-lead Kelvin sensing. Referring briefly to first structure 28 shown in FIG. 1, current may be supplied to first finger 34 via terminals 44, 50 (i.e., the current leads). The resulting voltage can be measured between terminals 46, 48 (i.e., voltage leads) and the resistance can be extracted via Ohm's Law, V=IR. The separation of current and voltage leads eliminates the lead and contact resistance from the measurement, which is advantageous for precise measurement of low resistance values. Alternative embodiments may employ a different resistance measurement technique for determining $R_1$, $R_2$, $R_3$.

At a block 126, static capacitances $C_1$, $C_2$, $C_3$ of corresponding first, second, and third structures 28, 30, 32 (FIG. 1) are determined. By way of example, $C_1$, $C_2$, $C_3$ may be measured by utilizing a capacitance measurement device (e.g., an LCR meter). Again referring to first structure 28 shown in FIG. 1, first and second contacts 52, 54 may be connected to the capacitance measurement device at a first potential (HIGH) and first pair of terminals 44, 46 and second pair of terminals 48, 50 may be connected to the capacitance measurement device at a second potential (LOW). First structure 28 is thereafter subjected to an alternating current (AC) voltage source. An LCR meter measures the voltage across and the current through first structure 28. From the ratio of the voltage and current, the LCR meter can determine the magnitude of the impedance. The phase angle between the voltage and current is also measured. The LCR meter can calculate the capacitance from the impedance and the phase angle. Alternative embodiments may employ a different capacitance measurement technique for determining $C_1$, $C_2$, $C_3$.

At a block 128 the measured resistances, $R_1$, $R_2$, $R_3$, and the measured capacitances, $C_1$, $C_2$, $C_3$, are utilized to compute etch undercut parameter, D, resistivity parameter, p, and thickness parameter, T, as discussed in detail above. Again, a computing system executing an algorithm containing the above equations may be utilized to compute etch undercut parameter, resistivity parameter, and thickness parameter. These computed critical parameters can be utilized in order optimize production yields, device performance, and quality of the semiconductor devices. Thereafter, critical parameter characterization process ends.

Embodiments are described above with a single "finger" per each of the structures (e.g., first structure 28 having first finger 34, second structure 30 having second finger 56, and third structure 32 having third finger 78 as shown in FIG. 1) for compactness and simplicity. Alternative embodiments may include multiple "fingers" per structure to yield higher measures capacitance values and lower measured resistance values.

Thus, a process control monitoring system and a method of characterizing critical parameters resulting from a semiconductor device fabrication process are discloses herein. An embodiment of a process control monitoring system formed on a substrate comprises a first structure formed in a structural layer of the substrate, the first structure including a first finger interposed between a first pair of sidewalls, the first finger exhibiting a first length and a first width, each of which is parallel to a surface of the substrate, and the first finger being separated from each of the first pair of sidewalls by a first gap having a first spacing. The process control monitoring system further comprises a second structure formed in the structural layer of the substrate, the second structure including a second finger interposed between a second pair of sidewalls, the second finger exhibiting a second length and the first width, each of which is parallel to the surface of the substrate, and the second finger being separated from each of the second pair of sidewalls by a second gap having the first spacing. And the system process control monitoring comprises a third structure formed in the structural layer of the substrate, the third structure including a third finger interposed between a third pair of sidewalls, the third finger exhibiting the second length and a second width, each of which is parallel to the surface of the substrate, and the third finger being separated from each of the third pair of sidewalls by a third gap having a second spacing. Each of the first, second, and third fingers includes a first end and a second end. For the each of the first, second, and third fingers, the process control monitoring system further comprises a first pair of terminals in electrical communication with the first end and a second pair of terminals in electrical communication with the second end. The first and second pairs of terminals are configured for connection with a four-terminal resistance measurement device to determine a resistance of the each of the first, second, and third fingers. Each of the first, second, and third pairs of sidewalls includes a first sidewall and a second sidewall. For the each of the first, second, and third pairs of sidewalls, the process control monitoring system further comprises a first contact and a second contact. The first contact is in electrical communication with the first sidewall and the second contact is in electrical communication with the second sidewall. The first and second electrical contacts are configured for connection with a capacitance measurement device at a first potential and the first and second pairs of terminals are further configured for connection with the capacitance measurement device at a second potential for determining a capacitance between the each of the first, second, and third fingers and associated the each of the first, second, and third pairs of sidewalls. The first length differs from the second length. The first width differs from the second width. The first spacing differs from the second spacing. The first width is equivalent to the first spacing. The second width is equivalent to the second spacing.

An embodiment of a method of characterizing critical parameters resulting from a semiconductor device fabrication process comprises implementing the semiconductor device fabrication process to form a process control monitoring system in a structural layer of a substrate. The process control monitoring system includes a first structure including a first finger interposed between a first pair of sidewalls, the first finger exhibiting a first length and a first width, each of which is parallel to a surface of the substrate, and the first finger being separated from each of the first pair of sidewalls by a first gap having a first spacing. The process control monitoring system further includes a second structure including a second finger interposed between a second pair of sidewalls, the second finger exhibiting a second length and the first width, each of which is parallel to the surface of the substrate, and the second finger being separated from each of the second pair of sidewalls by a second gap having the first spacing. And, the process control monitoring system further includes a third structure including a third finger interposed between a third pair of sidewalls, the third finger exhibiting the second length and a second width, each of which is parallel to the surface of the substrate, and the third finger being separated from each of the third pair of sidewalls by a third gap having a second spacing. The first length differs from the second length. The first width differs from the second width. The first spacing differs from the second spacing. The first width is equivalent to the first spacing. The second width is equivalent to the second spacing. The method further comprises determining the critical parameters based on the first and second lengths, the first and second widths, and the first and second spacings for associated ones of the first, second, and third fingers. The determining of the critical parameters comprises determining a first resistance $R_1$ of said first finger; determining a first capacitance $C_1$ between said first pair of sidewalls and said first finger; determining a second resistance $R_2$ of said second finger; determining a second capacitance $C_2$ between said second pair of sidewalls and second first finger; determining a third resistance $R_3$ of said third finger; determining a third capacitance $C_3$ between said third pair of sidewalls and third first finger; and computing said critical parameters based on said first, second, and third resistances $R_1$, $R_2$, $R_3$ and said first, second, and third capacitances $C_1$, $C_2$, $C_3$. An etch undercut parameter is computed:

$$D = \frac{1}{2}\sqrt{X_2^2 - \frac{(R_1-R_2)(C_1-C_2)L_2^2(X_2-X_1)^2}{(R_2-R_3)(C_2-C_3)(L_1-L_2)^2}}.$$ A resistivity parameter (ρ) of said substrate is computed:

$$\rho = \frac{(R_1-R_2)(C_1-C_2)(W_1-2D)(S_1+2D)}{2\varepsilon(L_1-L_2)^2}.$$ A thickness parameter (T) of said structural layer (22) perpendicular to said surface (24) of said substrate is computed: $$T = \frac{(C_1-C_2)(S_1+2D)}{2\varepsilon(L_1-L_2)}.$$ The etch undercut parameter D, said resistivity parameter ρ, and said thickness parameter T are said critical parameters.

An embodiment of a wafer structure comprises a substrate, a plurality of semiconductor devices formed in a structural layer of the substrate, and a process control monitoring system formed in a structural layer of the substrate, wherein the plurality of semiconductor devices and the process control monitoring system are fabricated concurrently using the same semiconductor device fabrication process.

The embodiments described herein enable the extraction of critical device parameters with a self-consistent analysis of the resistance and capacitance measurements on the structures in which these critical parameters are coupled. Further, these critical parameters are effectively decoupled by the simultaneous solution of coupled equations describing the resistance and capacitance measurements on the different structures. Accordingly, the resistance and capacitance measurements enable electrical characterization of, for example, a product wafer, in order to extract the critical device parameters of the electrical resistivity of the structural layer, the thickness of the structural layer, and the amount of undercut of the etched features. The system and associated methodology enables the extraction of these critical device parameters without the need for sacrificial wafers, cross sectioning, or the use of complex SEM analysis. Accordingly, variations in resistivity, material thickness, and amount of undercut can be readily monitored in order to optimize production yields, device performance, and the quality of semiconductor devices, such as microelectromechanical systems (MEMS) devices.

**Claims**

1. An etching process control monitoring system formed on a substrate comprising:

   a first structure (28) formed in a structural layer (22) of said substrate (26), said first structure (28) including a first finger (34) interposed between a first pair of sidewalls (36, 38), said first finger (34) exhibiting a first length ($L_1$) and a first width ($W_1$), each of which is parallel to a surface (24) of said substrate (26), and said first finger (34) being separated from each of said first pair of sidewalls (36, 38) by a first gap (106) having a first spacing ($S_1$); a second structure (30) formed in said structural layer (22) of said substrate (26), said second structure (30) including a second finger (56) interposed between a second pair of sidewalls (58, 60), said second finger (56) exhibiting a second length ($L_2$) and said first width ($W_1$), each of which is parallel to said surface (24) of said substrate (26), and said second finger (56) being separated from each of said second pair of sidewalls (58, 60) by a second gap (108) having said first spacing ($S_1$); and a third structure (32) formed in said structural layer (22) of said substrate (26), said third structure (32) including a third finger (78) interposed between a third pair of sidewalls (80, 82), said third finger (78) exhibiting said

second length ($L_2$) and a second width ($W_2$), each of which is parallel to said surface (24) of said substrate (26), and said third finger (78) being separated from each of said third pair of sidewalls (80, 82) by a third gap (110) having a second spacing ($S_2$), wherein each of said first, second, and third fingers (34, 56, 78) includes a first end (40, 62, 84) and a second end (42, 64, 86), wherein for said each of said first, second, and third fingers (34, 56, 78), said process control monitoring system (20) further comprises:

a first pair of terminals (44, 46, 66, 68, 88, 90) in electrical communication with said first end (40, 62, 84) and a second pair of terminals (48, 50, 70, 72, 92, 94) in electrical communication with said second end (42, 64, 86), said first and second pair of terminals (44, 46, 66, 68, 88, 90, 48, 50, 70, 72, 92, 94) being configured for connection with a four terminal resistance measurement device to determine a resistance of said each of said first, second, and third fingers (34, 56, 78), wherein each of said first, second, and third pairs of sidewalls (36, 38, 58, 60, 80, 82) includes a first sidewall (36, 58, 80) and a second sidewall (38, 60, 82), wherein for said each of said first, second, and third pairs of sidewalls (36, 38, 58, 60, 80, 82), said process control monitoring system (20) further comprises:

a first contact (52, 74, 96) and a second contact (54, 76, 98), said first contact (52, 74, 96) being in electrical communication with said first sidewall (36, 58, 80), and said second contact (54, 76, 98) being in electrical communication with said second sidewall (38, 60, 82), wherein said first and second electrical contacts (52, 74, 96, 54, 76, 98) are configured for connection with a capacitance measurement device at a first potential and said first and second pairs of terminals are further configured for connection with said capacitance measurement device at a second potential for determining a capacitance between said each of said first, second, and third fingers (34, 56, 78) and associated said each of said first, second, and third pairs of sidewalls (36, 38, 58, 60, 80, 82), wherein said process control monitoring system (20) is **characterized in that** said first length ($L_1$) differs from said second length ($L_2$); said first width ($W_1$) differs from said second width ($W_2$); said first spacing ($S_1$) differs from said second spacing ($S_2$); said first width ($W_1$) is equivalent to said first spacing ($S_1$); and said second width ($W_2$) is equivalent to said second spacing ($S_2$).

2. The etching process control monitoring system of claim 1, wherein each of said first, second, and third fingers (34, 56, 78) exhibits a thickness perpendicular to said surface (24) of said substrate (26), said thickness being equivalent for said each of said first, second, and third fingers (34, 56, 78).

3. The etching process control monitoring system of claim 1 or claim 2, wherein said first, second, and third fingers (34, 56, 78) are immovable relative to corresponding said first, second, and third pairs of sidewalls (36, 38, 58, 60, 80, 82).

4. The etching process control monitoring system of any one of the claims 1 to 3, wherein said first and second lengths ($L_1$, $L_2$), said first and second widths ($W_1$, $W_2$), and said first and second spacings ($S_1$, $S_2$) for associated ones of said first, second, and third fingers (34, 56, 78) are utilized to determine an etch undercut parameter (D) of said first, second, and third fingers (34, 56, 78); a resistivity parameter ($\rho$) of said substrate (26); and/or a thickness parameter (T) of said structural layer (22) perpendicular to said surface (24) of said substrate (26).

5. A wafer structure including the etching process control monitoring system of any one of the claims 1 to 4, wherein said wafer structure (100) further comprises a plurality of semiconductor devices (102) formed in said structural layer (22), said process control monitoring system (20) and said plurality of semiconductor devices (102) being fabricated concurrently using the same semiconductor device fabrication process.

6. A method of characterizing critical parameters resulting from a semiconductor device fabrication etching process comprising:

implementing (122) said semiconductor device fabrication process to form an etching process control monitoring system (20) as well as a plurality of semiconductor devices (102) in a structural layer (22) of a substrate (26), said process control monitoring system (20) including:

a first structure (28) including a first finger (34) interposed between a first pair of sidewalls (36, 38), said first finger (34) exhibiting a first length ($L_1$) and a first width ($W_1$), each of which is parallel to a surface (24) of said substrate (26), and said first finger (34) being separated from each of said first pair of sidewalls (36, 38) by a first gap (106) having a first spacing ($S_1$);

a second structure (30) including a second finger (56) interposed between a second pair of sidewalls (58, 60), said second finger (56) exhibiting a second length ($L_2$) and said first width ($W_1$), each of which is parallel to said surface (24) of said substrate (26), and said second finger (56) being separated from each of said second pair of sidewalls (58, 60) by a second gap (108) having said first spacing ($S_1$); and

a third structure (32) including a third finger (78) interposed between a third pair of sidewalls (80, 82), said third finger (78) exhibiting said second length ($L_2$) and a second width ($W_2$), each of which is parallel to said surface (24) of said substrate (26), and said third finger (78) being separated from each of said third pair of sidewalls (80, 82) by a third gap having a second spacing ($S_2$),

wherein:

said first length ($L_1$) differs from said second length (L2),
said first width (W1) differs from said second width (W2),
said first spacing (S1) differs from said second spacing (S2),
said first width (W1) is equivalent to said first spacing (S1), and
said second width (W2) is equivalent to said second spacing (S2); and

determining (124, 126) said critical parameters based on said first and second lengths ($L_1$, $L_2$), said first and second widths ($W_1$, $W_2$), and said first and second spacings ($S_1$, $S_2$) for associated ones of said first, second, and third fingers (34, 56, 78), wherein said determining (124, 126) said critical parameters comprises:

determining (124) a first resistance ($R_1$) of said first finger (34);
determining (126) a first capacitance ($C_1$) between said first pair of sidewalls (36, 38) and said first finger (34);
determining (124) a second resistance ($R_2$) of said second finger (56);
determining (126) a second capacitance ($C_2$) between said second pair of sidewalls (58, 60) and said second finger (56);
determining (124) a third resistance ($R_3$) of said third finger (78);
determining (126) a third capacitance ($C_3$) between said third pair of sidewalls (80, 82) and said third finger (78);
computing (128) said critical parameters based on said first, second, and third resistances ($R_1$, $R_2$, $R_3$) and said first, second, and third capacitances ($C_1$, $C_2$, $C_3$):
computing an etch undercut parameter (D):

$$D = \frac{1}{2}\sqrt{X_2^2 - \frac{(R_1-R_2)(C_1-C_2)L_2^2(X_2-X_1)^2}{(R_2-R_3)(C_2-C_3)(L_1-L_2)^2}};$$

where X1 = W1 = S1 and X2 = W2 = S2;
computing a resistivity parameter ($\rho$) of said substrate (26):

$$\rho = \frac{(R_1-R_2)(C_1-C_2)(W_1-2D)(S_1+2D)}{2\varepsilon(L_1-L_2)^2};$$

and
computing a thickness parameter (T) of said structural layer (22) perpendicular to said surface (24) of said substrate (26):

$$T = \frac{(C_1-C_2)(S_1+2D)}{2\varepsilon(L_1-L_2)},$$

wherein said etch undercut parameter (D), said resistivity parameter (p), and said thickness parameter (T) are said critical parameters.

7. The method of claim 6, wherein said implementing operation (122) forms said process control monitoring system (20) to have said first, second, third fingers (34, 56, 78) that are immovable relative to corresponding said first, second, and third pairs of sidewalls (36, 38, 58, 60, 80, 82).

8. The method of claim 6 or claim 7, wherein said determining each of said first, second, and third resistances ($R_1$, $R_2$, $R_3$) comprises measuring a Kelvin resistance of said each of said first, second, and third fingers (34, 56, 78).

9. The method of any one of the claims 6 to 8, further comprising implementing said semiconductor device fabrication process to produce a wafer structure (100) that includes said process control monitoring system (20) and a plurality of semiconductor devices (102) in said structural layer (22), wherein said critical parameters determined utilizing said first, second, and third structures (28, 30, 32) of said process control monitoring system (20) characterizes said critical parameters of said plurality of said semiconductor devices (102).

**Patentansprüche**

1. Ein Ätzprozess Steuer Überwachungssystem, welches ausgebildet ist auf einem Substrat, aufweisend:

eine erste Struktur (28), welche ausgebildet ist in einer Strukturschicht (22) von dem Substrat (26),
wobei die erste Struktur (28) einen ersten Finger (34) umfasst, welcher zwischengeschaltet ist zwischen einem ersten Paar von Seitenwänden (36, 38),
wobei der erste Finger (34) eine erste Länge ($L_1$) und eine erste Breite ($W_1$) besitzt,
wobei jede von denen parallel ist zu der Oberfläche (24) von dem Substrat (26), und
wobei der erste Finger (34) separiert ist von jedem von dem Paar von Seitenwänden (36, 38) durch einen ersten Spalt (106), welcher einen ersten Abstand ($S_1$) hat;
eine zweite Struktur (30), welche ausgebildet ist in der Strukturschicht (22) von dem Substrat (26),
wobei die zweite Struktur (30) einen zweiten Finger (56) umfasst, welcher zwischengeschaltet ist zwischen einem zweiten Paar von Seitenwänden (58, 60),
wobei der zweite Finger (56) eine zweite Länge ($L_2$) und eine zweite Breite ($W_2$) besitzt,
wobei jede von denen parallel ist zu der Oberfläche (24) von dem Substrat (26), und
wobei der zweite Finger (56) separiert ist von jedem von dem zweiten Paar von Seitenwänden (58, 60) durch einen zweiten Spalt (108), welcher den ersten Abstand ($S_1$) hat; und
eine dritte Struktur (32), welche ausgebildet ist in der Strukturschicht (22) von dem Substrat (26),
wobei die dritte Struktur (32) einen dritten Finger (78) umfasst, welcher zwischengeschaltet ist zwischen einem dritten Paar von Seitenwänden (80, 82),
wobei der dritte Finger (78) die zweite Länge ($L_2$) und die zweite Breite ($W_2$) besitzt,
wobei jede von denen parallel ist zu der Oberfläche (24) von dem Substrat (26), und
wobei der dritte Finger (78) separiert ist von jedem von dem dritten Paar von Seitenwänden (80, 82) durch einen dritten Spalt (110), welcher einen zweiten Abstand ($S_2$) hat,
wobei jeder von dem ersten, zweiten und dritten Finger (34, 56, 78) ein erstes Ende (40, 62, 84) und ein zweites Ende (42, 64, 86) umfasst,
wobei für jeden von dem ersten, zweiten und dritten Finger (34, 56, 78) das Prozess Steuer Überwachungssystem (20) ferner aufweist:
ein erstes Paar von Anschlüssen (44, 46, 66, 68, 88, 90) in elektrischer Kommunikation mit dem ersten Ende (40, 62, 84) und ein zweites Paar von Anschlüssen (48, 50, 70, 72, 92, 94) in elektrischer Kommunikation mit dem zweiten Ende (42, 64, 86), wobei das erste und zweite Paar von Anschlüssen (44, 46, 66, 68, 88, 90, 48, 50, 70, 72, 92, 94) konfiguriert sind zum Verbinden mit einer Vier Anschluss Widerstand Messvorrichtung zum Bestimmen eines Widerstandes von jedem von dem ersten, zweiten und dritten Finger (34, 56, 78),
wobei jeder von dem ersten, zweiten, und dritten Paar von Seitenwänden (36, 38, 58, 60, 80, 82) eine erste Seitenwand (36, 58, 80) und eine zweite Seitenwand (38, 60, 82) umfasst,
wobei für jedes von dem ersten, zweiten und dritten Paar von Seitenwänden (36, 38, 58, 60, 80, 82) das Prozess Steuer Überwachungssystem (20) ferner aufweist:
einen ersten Kontakt (52, 74, 96) und einen zweiten Kontakt (54, 76, 98),
wobei der erste Kontakt (52, 74, 96) in elektrischer Kommunikation ist mit der ersten Seitenwand (36, 58, 80), und
wobei der zweite Kontakt (54, 76, 98) in elektrischer Kommunikation ist mit der zweiten Seitenwand (38, 60, 82),
wobei der erste und zweite elektrische Kontakt (52, 74, 96, 54, 76, 98) konfiguriert sind zum Verbinden mit einer Kapazität Messvorrichtung bei einem ersten Potential und das erste und zweite Paar von Anschlüssen ferner konfiguriert sind zum Verbinden mit der Kapazität Messvorrichtung bei einem zweiten Potential zum Bestimmen einer Kapazität zwischen jedem von dem ersten, zweiten und dritten Finger (34, 56, 78) und assoziierten jedem von dem ersten, zweiten und dritten Paar von Seitenwänden (36, 38, 58, 60, 80, 82), wobei das Prozess Steuer Überwachungssystem (20) **dadurch gekennzeichnet ist, dass**

die erste Länge (L1) abweicht von der zweiten Länge ($L_2$);
die erste Breite ($W_1$) abweicht von der zweiten Breite ($W_2$);
der erste Abstand ($S_1$) abweicht von dem zweiten Abstand ($S_2$);
die erste Breite ($W_1$) äquivalent ist zu dem ersten Abstand ($S_1$); und
die zweite Breite ($W_2$) äquivalent ist zu dem zweiten Abstand ($S_2$).

2. Das Ätzprozess Steuer Überwachungssystem gemäß Anspruch 1,
wobei jeder von dem ersten, zweiten und dritten Finger (34, 56, 78) eine Dicke besitzt, die senkrecht zu der Oberfläche (24) von dem Substrat (26) ist,
wobei die Dicke äquivalent ist für jeden von dem ersten, zweiten und dritten Finger (34, 56, 78).

3. Das Ätzprozess Steuer Überwachungssystem gemäß Anspruch 1 oder Anspruch 2,
wobei der erste, zweite und dritte Finger (34, 56, 78) unbeweglich sind relativ zu entsprechenden von dem ersten, zweiten und dritten Paar von Seitenwänden (36, 38, 58, 60, 80, 82).

4. Das Ätzprozess Steuer Überwachungssystem gemäß irgendeinem der Ansprüche 1 bis 3, wobei die erste und zweite Länge ($L_1$, $L_2$), die erste und zweite Breite ($W_1$, $W_2$) und der erste und zweite Abstand ($S_1$, $S_2$) für assoziierte welche von dem ersten, zweiten und dritten Finger (34, 56, 78) benutzt werden zum Bestimmen

eines Ätz Unterschneidung Parameter (D) von dem ersten, zweiten und dritten Finger (34, 56, 78);
eines Widerstandsparameter (p) von dem Substrat (26); und/oder
eines Dickeparameters (T) von der Strukturschicht (22), welcher senkrecht zu der Oberfläche (24) von dem Substrat (26) ist.

5. Eine Waferstruktur umfassend das Ätzprozess Steuer Überwachungssystem gemäß irgendeinem der Ansprüche 1 bis 4,
wobei die Waferstruktur (100) ferner aufweist eine Mehrzahl von Halbleitervorrichtungen (102), welche ausgebildet sind in der Strukturschicht (22),
wobei das Prozess Steuer Überwachungssystem (20) und die Mehrzahl von Halbleitervorrichtungen (102) fabriziert sind simultan unter Verwenden desselben Halbleitervorrichtung Fabrikationsprozesses.

6. Ein Verfahren zum Kennzeichnen von kritischen Parametern, welche aus einem Halbleitervorrichtung Fabrikation Ätzprozess resultiert, aufweisend:

Implementieren (122) des Halbleitervorrichtung Fabrikationsprozesses zum Ausbilden eines Ätzungsprozess Steuer Überwachungssystem (20) wie auch eine Mehrzahl von Halbleitervorrichtungen (102) in eine Strukturschicht (22) von einem Substrat (26),
wobei das Prozess Steuer Überwachungssystem (20) umfasst:

eine erste Struktur (28), welche einen ersten Finger (34) umfasst, welcher zwischengeschaltet ist zwischen einem ersten Paar von Seitenwänden (36, 38),
wobei der erste Finger (34) eine erste Länge ($L_1$) und eine erste Breite ($W_1$) besitzt,
wobei jede von denen parallel ist zu einer Oberfläche (24) von dem Substrat (26), und wobei der erste Finger (34) separiert ist von jedem von dem ersten Paar von Seitenwänden (36, 38) durch einen ersten Spalt (106), welcher einen ersten Abstand ($S_1$) hat;
eine zweite Struktur (30), welche einen zweiten Finger (56) umfasst, welcher zwischengeschaltet ist zwischen einem zweiten Paar von Seitenwänden (58, 60),
wobei der zweite Finger (56) eine zweite Länge ($L_2$) und die erste Breite ($W_1$) besitzt,
wobei jede von denen parallel ist zu der Oberfläche (24) von dem Substrat (26), und
wobei der zweite Finger (56) separiert ist von jedem von dem zweiten Paar von Seitenwänden (58, 60) durch einen zweiten Spalt (108), welcher den ersten Abstand ($S_1$) hat; und
eine dritte Struktur (32), welche einen dritten Finger (78) umfasst, welcher zwischengeschaltet ist zwischen einem dritten Paar von Seitenwänden (80, 82),
wobei der dritte Finger (78) die zweite Länge ($L_2$) und eine zweite Breite ($W_2$) besitzt, wobei jede von denen parallel ist zu der Oberfläche (24) von dem Substrat (26), und
wobei der dritte Finger (78) separiert ist von jedem von den dritten Paar von Seitenwänden (80, 82) durch einen dritten Spalt, welcher einen zweiten Abstand ($S_2$) hat,
wobei:

die erste Länge (L1) abweicht von der zweiten Länge (L2),
die erste Breite (W1) abweicht von der zweiten Breite (W2),
der erste Abstand (S1) abweicht von dem zweiten Abstand (S2),
die erste Breite (W1) äquivalent ist zu dem ersten Abstand (S1), und
die zweite Breite (W2) äquivalent ist zu dem zweiten Abstand (S2); und

Bestimmen (124, 126) der kritischen Parameter basierend auf der ersten und zweiten Länge ($L_1$, $L_2$), der ersten und zweiten Breite ($W_1$, $W_2$) und dem ersten und zweiten Abstand ($S_1$, $S_2$) für assoziierte welche von dem ersten, zweiten und dritten Finger (34, 56, 78), wobei das Bestimmen (124, 126) der kritischen Parameter aufweist:

Bestimmen (124) eines ersten Widerstands ($R_1$) von dem ersten Finger (34);
Bestimmen (126) einer ersten Kapazitanz ($C_1$) zwischen dem ersten Paar von Seitenwänden (36, 38) und dem ersten Finger (34);
Bestimmen (124) eines zweiten Widerstands ($R_2$) von dem zweiten Finger (56);
Bestimmen (126) einer zweiten Kapazitanz ($C_2$) zwischen dem zweiten Paar von Seitenwänden (58, 60) und dem zweiten Finger (56);
Bestimmen (124) eines dritten Widerstands ($R_3$) von dem dritten Finger (78);
Bestimmen (126) einer dritten Kapazitanz ($C_3$) zwischen dem dritten Paar von Seitenwänden (80, 82) und dem dritten Finger (78);
Berechnen (128) der kritischen Parameter basierend auf dem ersten, zweiten und dritten Widerstand ($R_1$, $R_2$, $R_3$) und der ersten, zweiten und dritten Kapazitanz ($C_1$, $C_2$, $C_3$):

Berechnen eines Ätz Unterschneidung Parameters (D):

$$D = \frac{1}{2}\sqrt{X_2^2 - \frac{(R_1-R_2)(C_1-C_2)L_2^2(X_2-X_1)^2}{(R_2-R_3)(C_2-C_3)(L_1-L_2)^2}};$$

wo X1 = $W_1$ = $S_1$ und X2 = $W_2$ = $S_2$;
Berechnen eines Widerstandsparameters ($\rho$) von dem Substrat (26):

$$\rho = \frac{(R_1-R_2)(C_1-C_2)(W_1-2D)(S_1+2D)}{2\varepsilon(L_1-L_2)^2};$$

und
Berechnen eines Dickeparameters (T) von der Strukturschicht (22), welcher senkrecht zu der Oberfläche (24) von dem Substrat (26) ist:

$$T = \frac{(C_1-C_2)(S_1+2D)}{2\varepsilon(L_1-L_2)};$$

wobei der Ätz Unterschneidung Parameter (D), der Widerstandsparameter ($\rho$), und der Dickeparameter (T) die kritischen Parameter sind.

7. Das Verfahren gemäß Anspruch 6,
wobei die Implementieroperation (122) das Prozess Steuerung Überwachungssystem (20) ausbildet zum Haben des ersten, zweiten, dritten Fingers (34, 56, 78), welche unbeweglich sind relativ zu entsprechenden des ersten, zweiten und dritten Paares von Seitenwänden (36, 38, 58, 60, 80, 82).

8. Das Verfahren gemäß Anspruch 6 oder Anspruch 7,
wobei das Bestimmen von jedem von dem ersten, zweiten und dritten Widerstand ($R_1$, $R_2$, $R_3$) aufweist Messen eines Kelvinwiderstandes von jedem von dem ersten, zweiten und dritten Finger (34, 56, 78).

9. Das Verfahren gemäß irgendeinem der Ansprüche 6 bis 8, ferner aufweisend
Implementieren des Halbleitervorrichtung Fabrikationsprozesses zum Produzieren einer Waferstruktur (100), welche umfasst das Prozess Steuer Überwachungssystem (20) und eine Mehrzahl von Halbleitervorrichtungen (102) in der Strukturschicht (22),
wobei die kritischen Parameter, welche bestimmt werden ausnutzend die erste, zweite und dritte Struktur (28, 30, 32) von dem Prozess Steuer Überwachungssystem (20), kennzeichnen die kritischen Parameter von der Mehrzahl von dem Halbleitervorrichtungen (102).


**Revendications**

1. Système de surveillance de contrôle de procédé de gravure formé sur un substrat comprenant :

une première structure (28) formée dans une couche structurale (22) dudit substrat (26), ladite première structure (28) comportant un premier doigt (34) intercalé entre une première paire de parois latérales (36, 38), ledit premier doigt (34) présentant une première longueur ($L_1$) et une première largeur ($W_1$), dont chacune est parallèle à une surface (24) dudit substrat (26), et ledit premier doigt (34) étant séparé de chaque paroi de ladite première paire de parois latérales (36, 38) par un premier interstice (106) ayant un premier espacement ($S_1$) ;
une deuxième structure (30) formée dans ladite couche structurale (22) dudit substrat (26), ladite deuxième structure (30) comportant un deuxième doigt (56) intercalé entre une deuxième paire de parois latérales (58, 60), ledit deuxième doigt (56) présentant une deuxième longueur ($L_2$) et ladite première largeur ($W_1$), dont chacune est parallèle à ladite surface (24) dudit substrat (26), et ledit deuxième doigt (56) étant séparé de chaque paroi de ladite deuxième paire de parois latérales (58, 60) par un deuxième interstice (108) ayant ledit premier espacement ($S_1$) ; et
une troisième structure (32) formée dans ladite couche structurale (22) dudit substrat (26), ladite troisième structure (32) comportant un troisième doigt (78) intercalé entre une troisième paire de parois latérales (80, 82), ledit troisième doigt (78) présentant ladite deuxième longueur ($L_2$) et une deuxième largeur ($W_2$), dont chacune est parallèle à ladite surface (24) dudit substrat (26), et ledit troisième doigt (78) étant séparé de chaque paroi de ladite troisième paire de parois latérales (80, 82) par un troisième interstice (110) ayant un deuxième espacement ($S_2$),
dans lequel chacun desdits premier, deuxième et troisième doigts (34, 56, 78) comporte une première extrémité (40, 62, 84) et une deuxième extrémité (42, 64, 86), dans lequel pour ledit chacun desdits premier, deuxième et troisième doigts (34, 56, 78), ledit système de surveillance de contrôle de procédé (20) comprend en outre :

une première paire de bornes (44, 46, 66, 68, 88, 90) en communication électrique avec ladite première extrémité (40, 62, 84) et une deuxième paire de bornes (48, 50, 70, 72, 92, 94) en communication électrique avec ladite deuxième extrémité (42, 64, 86), lesdites première et deuxième paires de bornes (44, 46, 66, 68, 88, 90, 48, 50, 70, 72, 92, 94) étant configurées pour être branchées à un dispositif de mesure de résistance à quatre bornes pour déterminer une résistance dudit chacun desdits premier, deuxième et troisième doigts (34, 56, 78),
dans lequel chacune desdites première, deuxième et troisième paires de parois latérales (36, 38, 58, 60, 80, 82) comporte une première paroi latérale (36, 58, 80) et une deuxième paroi latérale (38, 60, 82), dans lequel pour ladite chacune desdites première, deuxième et troisième paires de parois latérales (36, 38, 58, 60, 80, 82), ledit système de surveillance de contrôle de procédé (20) comprend en outre :

un premier contact (52, 74, 96) et un deuxième contact (54, 76, 98), ledit premier contact (52, 74, 96) étant en communication électrique avec ladite première paroi latérale (36, 58, 80), et ledit deuxième contact (54, 76, 98) étant en communication électrique avec ladite deuxième paroi latérale (38, 60, 82), lesdits premier et deuxième contacts électriques (52, 74, 96, 54, 76, 98) étant configurés pour être branchés à un dispositif de mesure de capacité à un premier potentiel, et lesdites première et deuxième paires de bornes étant également configurées pour être branchées audit dispositif de mesure de capacité à un deuxième potentiel pour déterminer une capacité entre ledit chacun desdits premier, deuxième et troisième doigts (34, 56, 78) et ladite chacune desdites première, deuxième et troisième paires de parois latérales (36, 38, 58, 60, 80, 82) qui est associée,

ledit système de surveillance de contrôle de procédé (20) étant **caractérisé en ce que**

ladite première longueur ($L_1$) diffère de ladite deuxième longueur ($L_2$) ;
ladite première largeur ($W_1$) diffère de ladite deuxième largeur ($W_2$) ;
ledit premier espacement ($S_1$) diffère dudit deuxième espacement ($S_2$) ;
ladite première largeur ($W_1$) est équivalente audit premier espacement ($S_1$) ; et
ladite deuxième largeur ($W_2$) est équivalente audit deuxième espacement ($S_2$).

2. Système de surveillance de contrôle de procédé de gravure de la revendication 1, dans lequel chacun desdits premier, deuxième et troisième doigts (34, 56, 78) présente une épaisseur perpendiculairement à ladite surface (24) dudit substrat (26), ladite épaisseur étant équivalente pour ledit chacun desdits premier, deuxième et troisième doigts (34, 56, 78).

3. Système de surveillance de contrôle de procédé de gravure de la revendication 1 ou la revendication 2, dans lequel lesdits premier, deuxième et troisième doigts (34, 56, 78) sont immobiles par rapport auxdites première, deuxième et troisième paires de parois latérales (36, 38, 58, 60, 80, 82) correspondantes.

4. Système de surveillance de contrôle de procédé de gravure de l'une quelconque des revendications 1 à 3, dans lequel lesdites première et deuxième longueurs ($L_1$, $L_2$), lesdites première et deuxième largeurs ($W_1$, $W_2$) et lesdits premier et deuxième espacements ($S_1$, $S_2$) pour ceux associés desdits premier, deuxième et troisième doigts (34, 56, 78) sont utilisés pour déterminer

un paramètre de gravure sous-jacente (D) desdits premier, deuxième et troisième doigts (34, 56, 78) ;
un paramètre de résistivité ($\rho$) dudit substrat (26) ; et/ou
un paramètre d'épaisseur (T) de ladite couche structurale (22) perpendiculairement à ladite surface (24) dudit substrat (26).

5. Structure de tranche comportant le système de surveillance de contrôle de procédé de gravure de l'une quelconque des revendications 1 à 4, ladite structure de tranche (100) comprenant en outre une pluralité de dispositifs semi-conducteurs (102) formés dans ladite couche structurale (22), ledit système de surveillance de contrôle de procédé (20) et ladite pluralité de dispositifs semi-conducteurs (102) étant fabriqués simultanément en utilisant le même procédé de fabrication de dispositifs semi-conducteurs.

6. Procédé de caractérisation de paramètres critiques résultant d'un procédé de gravure de fabrication de dispositifs semi-conducteurs comprenant :

la mise en oeuvre (122) dudit procédé de fabrication de dispositifs semi-conducteurs pour former un système de surveillance de contrôle de procédé de gravure (20) ainsi qu'une pluralité de dispositifs semi-conducteurs (102) dans une couche structurale (22) d'un substrat (26), ledit système de surveillance de contrôle de procédé (20) comportant :

une première structure (28) comportant un premier doigt (34) intercalé entre une première paire de parois latérales (36, 38), ledit premier doigt (34) présentant une première longueur ($L_1$) et une première largeur ($W_1$), dont chacune est parallèle à une surface (24) dudit substrat (26), et ledit premier doigt (34) étant séparé de chaque paroi de ladite première paire de parois latérales (36, 38) par un premier interstice (106) ayant un premier espacement ($S_1$) ;
une deuxième structure (30) comportant un deuxième doigt (56) intercalé entre une deuxième paire de parois latérales (58, 60), ledit deuxième doigt (56) présentant une deuxième longueur ($L_2$) et ladite première largeur ($W_1$), dont chacune est parallèle à ladite surface (24) dudit substrat (26), et ledit deuxième doigt (56) étant séparé de chaque paroi de ladite deuxième paire de parois latérales (58, 60) par un deuxième interstice (108) ayant ledit premier espacement ($S_1$) ; et
une troisième structure (32) comportant un troisième doigt (78) intercalé entre une troisième paire de parois latérales (80, 82), ledit troisième doigt (78) présentant ladite deuxième longueur ($L_2$) et une deuxième largeur ($W_2$), dont chacune est parallèle à ladite surface (24) dudit substrat (26), et ledit troisième doigt (78) étant séparé de chaque paroi de ladite troisième paire de parois latérales (80, 82) par un troisième interstice ayant un deuxième espacement ($S_2$),
dans lequel :

ladite première longueur ($L_1$) diffère de ladite deuxième longueur ($L_2$) ;
ladite première largeur ($W_1$) diffère de ladite deuxième largeur ($W_2$) ;
ledit premier espacement ($S_1$) diffère dudit deuxième espacement ($S_2$) ;
ladite première largeur ($W_1$) est équivalente audit premier espacement ($S_1$) ; et
ladite deuxième largeur ($W_2$) est équivalente audit deuxième espacement ($S_2$) ; et

la détermination (124, 126) desdits paramètres critiques sur la base desdites première et deuxième longueurs ($L_1$, $L_2$), desdites première et deuxième largeurs ($W_1$, $W_2$) et desdits premier et deuxième espacements ($S_1$, $S_2$) pour ceux associés desdits premier, deuxième et troisième doigts (34, 56, 78), ladite détermination (124, 126) desdits paramètres critiques comprenant :

la détermination (124) d'une première résistance ($R_1$) dudit premier doigt (34) ;
la détermination (126) d'une première capacité ($C_1$) entre ladite première paire de parois latérales (36, 38) et ledit premier doigt (34) ;
la détermination (124) d'une deuxième résistance ($R_2$) dudit deuxième doigt (56) ;
la détermination (126) d'une deuxième capacité ($C_2$) entre ladite deuxième paire de parois latérales (58, 60) et ledit deuxième doigt (56) ;
la détermination (124) d'une troisième résistance ($R_3$) dudit troisième doigt (78) ;
la détermination (126) d'une troisième capacité ($C_3$) entre ladite troisième paire de parois latérales (80, 82) et ledit troisième doigt (78) ;
le calcul (128) desdits paramètres critiques sur la base desdites première, deuxième et troisième résistances ($R_1$, $R_2$, $R_3$) et desdites première, deuxième et troisième capacités ($C_1$, $C_2$, $C_3$) ;
le calcul d'un paramètre de gravure sous-jacente (D) :

$$D = \frac{1}{2}\sqrt{X_2^2 - \frac{(R_1 - R_2)(C_1 - C_2)L_2^2(X_2 - X_1)^2}{(R_2 - R_3)(C_2 - C_3)(L_1 - L_2)^2}}$$

où $X_1 = W_1 = S_1$ et $X_2 = W_2 = S_2$ ;
le calcul d'un paramètre de résistivité (ρ) dudit substrat (26) :

$$\rho = \frac{(R_1 - R_2)(C_1 - C_2)(W_1 - 2D)(S_1 + 2D)}{2\varepsilon(L_1 - L_2)^2} \; ;$$

et

le calcul d'un paramètre d'épaisseur (T) de ladite couche structurale (22) perpendiculairement à ladite surface (24) dudit substrat (26) :

$$T = \frac{(C_1 - C_2)(S_1 + 2D)}{2\varepsilon(L_1 - L_2)},$$

dans lequel ledit paramètre de gravure sous-jacente (D), ledit paramètre de résistivité (ρ) et ledit paramètre d'épaisseur (T) sont lesdits paramètres critiques.

7. Procédé de la revendication 6, dans lequel ladite opération de mise en oeuvre (122) forme ledit système de surveillance de contrôle de procédé (20) pour avoir lesdits premier, deuxième et troisième doigts (34, 56, 78) qui sont immobiles par rapport auxdites première, deuxième et troisième paires de parois latérales (36, 38, 58, 60, 80, 82) correspondantes.

8. Procédé de la revendication 6 ou la revendication 7, dans lequel ladite détermination de chacune desdites première, deuxième et troisième résistances ($R_1$, $R_2$, $R_3$) comprend la mesure d'une résistance en kelvins dudit chacun desdits premier, deuxième et troisième doigts (34, 56, 78).

9. Procédé de l'une quelconque des revendications 6 à 8, comprenant en outre la mise en oeuvre dudit procédé de fabrication de dispositifs semi-conducteurs pour produire une structure de tranche (100) qui comporte ledit système de surveillance de contrôle de procédé (20) et une pluralité de dispositifs semi-conducteurs (102) dans ladite couche structurale (22), lesdits paramètres critiques déterminés en utilisant lesdites première, deuxième et troisième structures (28, 30, 32) dudit système de surveillance de contrôle de procédé (20) caractérisant lesdits paramètres critiques de ladite pluralité desdits dispositifs semi-conducteurs (102).

# FIG . 1

# FIG . 2

100

# FIG . 3

# *FIG . 4*

30

# FIG . 5

# FIG. 6

CRITICAL PARAMETER
CHARACTERIZATION PROCESS — 120

↓

SEMICONDUCTOR DEVICE FABRICATION PROCESS — 122

- FORM SEMICONDUCTOR DEVICES
- FORM PROCESS CONTROL MONITORING SYSTEM

↓

DETERMINE RESISTANCES
$R_1, R_2, R_3$ — 124

↓

DETERMINE CAPACITANCES
$C_1, C_2, C_3$ — 126

↓

UTILIZE RESISTANCES AND CAPACITANCES
TO COMPUTE ETCH UNDERCUT PARAMETER
(D), RESISTIVITY PARAMETER ($\rho$), AND
THICKNESS PARAMETER (T) — 128

↓

END

**REFERENCES CITED IN THE DESCRIPTION**

**Patent documents cited in the description**

- US 2003022397 A1